# EUROPEAN PATENT SPECIFICATION

(11) **EP 2 557 908 B1**
(45) Date of publication and mention of the grant of the patent: **18.07.2018**
(21) Application number: 11765104.2
(22) Date of filing: 16.05.2011
(51) Int. Cl.: H05K 7/20, F28D 15/02

(54) **HEAT DISSIPATER AND OUTDOOR COMMUNICATION DEVICE**
WÄRMEUNTERDRÜCKER UND AUSSENKOMMUNIKATIONSVORRICHTUNG
DISSIPATEUR DE CHALEUR ET DISPOSITIF DE COMMUNICATION EXTÉRIEUR

(43) Date of publication of application: 13.02.2013
(73) Proprietor: Huawei Technologies Co., Ltd., Longgang District Shenzhen, Guangdong 518129 (CN)
(72) Inventor: LIN, Hui, Shenzhen Guangdong 518129 (CN); FENG, Taqing, Shenzhen Guangdong 518129 (CN)
(74) Representative: Thun, Clemens
(86) International application number: PCT/CN2011/074103
(87) International publication number: WO 2011/124186

(56) References cited:
- CN-U- 201 733 212
- CN-Y- 201 084 722
- JP-A- S62 297 697
- US-A- 6 024 165

## Description

### TECHNICAL FIELD

The present invention relates to heat exchange techniques, and more specifically, to a heat dissipation apparatus and an outdoor communication device.

### DESCRIPTION OF THE RELATED ART

In communication networks, there are a large number of outdoor communication devices arranged in open fields, for example, large power cabinets of communication base stations. Because these outdoor communication devices produce heat in their operation, and they can only operate appropriately in a certain range of temperatures, heat dissipation apparatus must be disposed for these outdoor communication devices.

JP S62 297697 A disclose a heat exchanger which is constituted of various modules of predetermined function and predetermined number of set, which are combined and connected with each other as modular units. In Dl, a heat exchanger is built from separate modules allowing multiple configurations.

US 6 024 165 A disclose a thermal management device and system for an electronic component enclosure, wherein the enclosure disposed in an environment exposed to ambient air and having an interior area for housing heat generating electronic components includes a heat exchanger having an evaporator portion and a condenser portion, the evaporator portion is adapted for mounting within the enclosure interior area adjacent to the heat generating electronic components. The condenser portion is exposed to the ambient air for removal of heat from the enclosure interior area generated by the electronic components adjacent to the heat exchanger evaporator portion. The device is incorporated in a system which includes an air duct disposed within the enclosure interior area. The duct includes an air inlet port and air outlet port. The ports communicate with the ambient air to thereby create an airflow path through the air duct from the inlet port to the outlet port. The condenser portion of the heat exchanger is adapted to communicate with the air flow path within the air duct, such that heat generated by the electronic components adjacent to the heat evaporator portion of the heat exchanger within the enclosure is removed from the enclosure through the air duct to the environment.

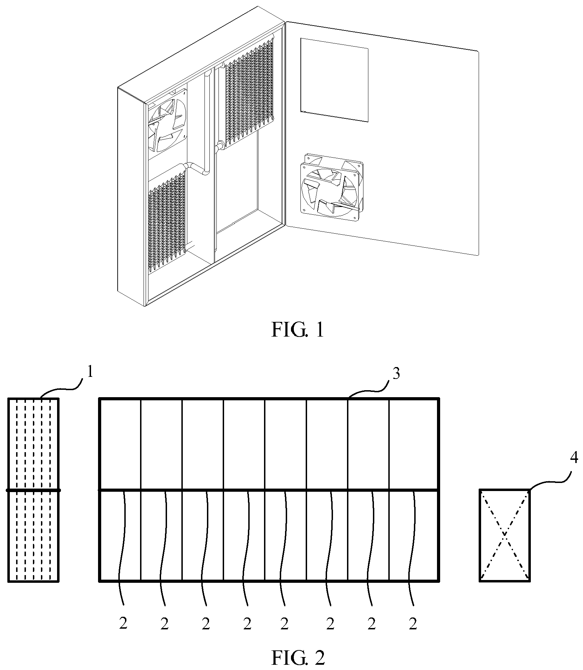

Fig.1 is a schematic structure diagram of a heat dissipation apparatus in the prior art. As shown in Fig.1, the heat dissipation apparatus comprises: an internal circulation heat exchange unit, an external circulation heat exchange unit, a vapor rising pipe, a liquid dropping pipe, an internal circulation fan, an external circulation fan, and air passage partitions. Wherein the internal circulation heat exchange unit, the external circulation heat exchange unit, the vapor rising pipe, and the liquid dropping pipe are communicated internally and accommodate refrigerant therein. In the design of the heat dissipation apparatus described above, it is needed to design the heat dissipation performance of the internal circulation heat exchange unit and the external circulation heat exchange unit and the performance of the internal circulation fan and the external circulation fan according to the working powers and operation conditions of the outdoor communication device. After the development of a heat dissipation apparatus has been completed, its heat dissipation performance is fixed.

When constructing communication networks, operators provide corresponding numbers of service boards in their outdoor communication devices according to their service demands, and always preserve some spare slots for service board arrangement. After the original construction of communication networks, dilation in communication networks is needed with the increase of service demands, thus, additional service boards may be inserted in the above spare slots to realize update of outdoor communication devices. After update, there may be a change in the working power of an outdoor communication device, as a result, a heat dissipation apparatus provided in the original construction of a communication network may be no longer suitable for the updated outdoor communication device. Presently, in the design of a heat dissipation apparatus, if the probability of sequential updates of an outdoor communication device is considered, the heat dissipation apparatus has to be designed according to the working power when a maximum number of service boards are provided for the outdoor communication device, thereby, manufacturing cost may increase, and there may be a waste in cost if the outdoor communication device is not provided with a maximum number of service boards. However, if a heat dissipation apparatus is provided only according to the working power of an outdoor communication device specified in the original communication network construction, if a update is needed for the outdoor communication device later, the outdoor communication device must be replaced as a whole, leading to a larger waste in cost. In summary, the existing heat dissipation apparatus can not be updated synchronization with outdoor communication devices, leading to waste in production cost of outdoor communication devices.

### SUMMARY OF THE INVENTION

A heat dissipation apparatus is provided in one embodiment of this invention, for addressing defects in the prior art and lowering manufacturing cost.

An outdoor communication device is provided in one embodiment of this invention, for addressing defects in the prior art and lowering manufacturing cost.

A heat dissipation device is further provided in one embodiment of this invention, comprising: one or more thermosiphon heat exchange units, one or more first partitions, and a frame having at least two lattices; wherein
each of the one or more thermosiphon heat exchange units is embedded in one lattice of the at least two lattices;
each lattice of the at least two lattices having no thermosiphon heat exchange unit embedded therein is disposed with one of the one or more first partitions to partition the lattice into an upper portion and a lower portion, wherein the first partition is detachable,
the thermosiphon heat exchange unit comprises:
a condensation end collection pipe in the upper portion of the thermosiphon heat exchange unit;
a vapor end collection pipe in the lower portion of the thermosiphon heat exchange unit;
at least two cooling tubules which are connected to the vapor end collection pipe and the condensation end collection pipe;
cooling fins evenly distributed between every two cooling tubules; and
a second partition that partitions the thermosiphon heat exchange unit into an upper portion and a lower portion;
wherein refrigerant is accommodated in the vapor end collection pipe, the condensation end collection pipe, and the cooling tubules,
the upper portion of the lattice is a first half lattice, and the lower portion is a second half lattice; and wherein the heat dissipation apparatus further comprises:
one or more fan units;
   wherein,
each fan unit of the one or more fan units is embedded in the first half lattice or the second half lattice,
the lower portion of all of the lattices is arranged in an internal circulation air passage to contact with heat air produced by a device where the heat dissipation apparatus is located, and the upper portion of all of the lattices is arranged in an external circulation air passage to contact cool air outside the heat dissipation apparatus, wherein the internal circulation air passage is isolated from the external circulation air passage by a plurality of first partitions; and
a number of the thermosiphon heat exchange units is determined according to a number of the one or more service boards to be cooled.

An outdoor communication device comprising one or more service boards and the above heat dissipation apparatus is further provided in one embodiment of this invention.

From the above technical solution, it can be seen that, in embodiments of this invention, through modular design, the frame of a heat dissipation apparatus may have a plurality of lattices in each of which a thermosiphon heat exchange unit can be embedded, the number of the embedded thermosiphon heat exchange units can be increased or decreased at any time depending on heat dissipation performance that is required, the synchronized update of the heat dissipation apparatus with the device where the heat dissipation apparatus is disposed can be implemented, a waste in cost caused when the heat dissipation apparatus is designed according to its maximum required heat dissipation performance can be avoided, and manufacturing cost can be saved. Furthermore, the heat dissipation apparatus is plug-and-play, which may facilitate mount and maintenance, and the update requirement of devices can be met.

### BRIEF DESCRIPTION OF THE DRAWINGS

For a more explicit description of technical solutions of embodiments of this invention or the prior art, a brief introduction of accompanying drawings to be used in the description of these embodiments and the prior art will be given below. Obviously, accompanying drawings described below are merely some embodiments of this invention, for those skilled in the art, other accompanying drawings can be derived from these ones without any creative efforts.
Fig.1 is a schematic structural diagram of an existing heat dissipation apparatus;
Fig.2 is a schematic structural diagram of an unassembled heat dissipation apparatus according to Embodiment 1 of this invention;
Fig.3 is a schematic structural diagram of a thermosiphon heat exchange unit according to Embodiment 2 of this invention;
Fig.4 is a schematic structural diagram of an assembled heat dissipation apparatus according to Embodiment 3 of this invention.

### DETAILED DESCRIPTION OF THE PREFERRED EMBODIMENT

For a better clarity of objects, technical solutions, and advantages of the embodiments of this invention, a clear and complete description of technical solutions of embodiments of this invention will be given in connection with accompanying drawings of those embodiments. Obviously, embodiments described herein are merely some embodiments of this invention, but not all of them. Based on those embodiments of this invention, other embodiments can occur to those skilled in the art without any creative efforts, all of which fall within the scope of this invention.

Fig.2 is a schematic structural diagram of an unassembled heat dissipation apparatus according to Embodiment 1 of this invention. As shown in Fig.2, the heat dissipation apparatus at least comprises: one or more thermosiphon heat exchange units 1, one or more first partitions 2, and a frame 3 having at least two lattices. Particularly, each of the one or more thermosiphon heat exchange units 1 is embedded in one lattice of the at least two lattices. Each lattice of the at least two lattices having no thermosiphon heat exchange unit 1 embedded is disposed with the first partition 2 to partition the lattice into an upper portion and a lower portion, where the first partition 2 is detachable.

Based on the above technical solution, the heat dissipation apparatus may further comprise: at least a fan unit 4. Particularly, each fan unit 4 is embedded in a half lattice constructed by the frame 3 and a first partition 2.

Hereinafter, through Embodiment 2 of this invention, a detail description will be given for the thermosiphon heat exchange unit 1 of the above technical solution.

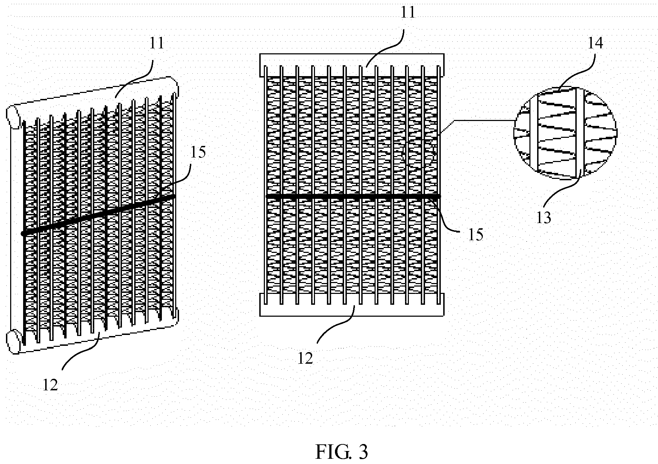

Fig.3 is a schematic structural diagram of a thermosiphon heat exchange unit according to Embodiment 2 of this invention. In the Embodiment 2 of this invention, the thermosiphon heat exchange unit 1 is an enhanced heat exchange fin type thermosiphon tube. As shown in Fig.3, each of the one or more thermosiphon heat exchange units 1 comprises: a condensation end collection pipe 11 in the upper portion of the thermosiphon heat exchange unit, a vapor end collection pipe 12 in the lower portion of the thermosiphon heat exchange unit, at least two cooling tubules 13 which are connected to the vapor end collection pipe 12 and the condensation end collection pipe 11, cooling fins 14 evenly distributed between every two cooling tubules 13, and a second partition 15 partitioning the thermosiphon heat exchange unit 1 into an upper portion and a lower portion.

The cooling fins 14 described above may have various shapes, preferably, the cooling fins 14 described above are ripple-shaped cooling fins.

Refrigerant is accommodated in the vapor end collection pipe 12, condensation end collection pipe 11, and cooling tubules 13. Particularly, the refrigerant may be, but not limit to, any one of the following materials: ammonia, acetone, or R134A type refrigerant.

The thermosiphon heat exchange unit 1 is portioned by the second partition 15. The lower portion of the partitioned thermosiphon heat exchange unit 1 comprises the vapor end collection pipe 12 and the lower portion of each cooling tubule 13, which is arranged in an internal circulation air passage to contact with the heat air produced by a device where the heat dissipation apparatus is provided. In the cooling tubules 13 at the lower portion, liquid refrigerant makes heat exchange with heat air, the refrigerant absorbing heat and then turning into vapor through vaporization. The vapor rises into the upper portion of the thermosiphon heat exchange unit 1 that is portioned along the cooling tubules 13. The portioned upper portion of the thermosiphon heat exchange unit 1 comprises the condensation end collection pipe 11 and the upper portion of each cooling tubule 13, which is arranged in an external circulation air passage to contact with the cool air outside of the heat dissipation apparatus. In the cooling tubules 13 at the upper portion, refrigerant vapor makes heat exchange with the cool air to disperse heat, and then returns into liquid state through condensation. Liquid refrigerant flows downward along the cooling tubules 13 due to gravity, returning to the lower portion of the thermosiphon heat exchange unit 1 that is portioned. Through such an interchanging circulation, heat in the interior of the heat dissipation apparatus can be transmitted to the outside to realize heat dissipation.

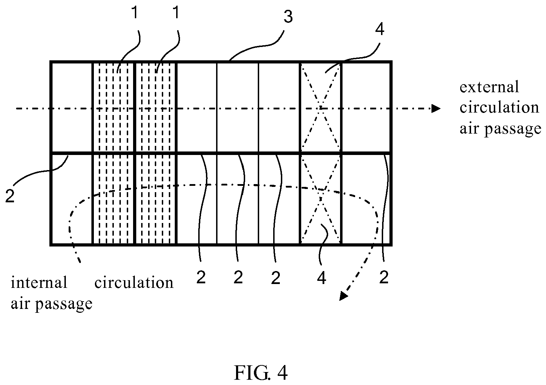

Fig.4 is a schematic structural diagram of an assembled heat dissipation apparatus according to Embodiment 3 of this invention. In Embodiment 3 of this invention, taking the assembly of a heat dissipation apparatus as an example, the heat dissipation apparatus of Embodiment 1 of this invention is assembled. As shown in Fig.4, the heat dissipation apparatus comprises: a frame 3 having 8 lattices, 2 thermosiphon heat exchange units 1 and 6 first partitions 2. Wherein, the 2 thermosiphon heat exchange units 1 are embedded in a second and a third lattices respectively. For each of other lattices having no thermosiphon heat exchange units 1 embedded, a first partition 2 is disposed therein to partition the lattice where the partition is disposed into upper and lower portions. Furthermore, those first partitions 2 are detachable.

In the assembled heat dissipation apparatus, a plurality of lattices each are partitioned into upper and lower portions with a plurality of first partitions 2. Wherein, the lower portion of all of the lattices is arranged in an internal circulation air passage to contact with heat air produced by a device where the heat dissipation apparatus is located. The upper portion of all of the lattices is arranged in an external circulation air passage to contact cool air outside the heat dissipation apparatus. The internal circulation air passage is isolated from the external circulation air passage by a plurality of first partitions 2.

In practical applications, the number of the thermosiphon heat exchange units 1 is determined according to required heat dissipation performance. When the outdoor communication device where the heat dissipation apparatus is located is updated, first partitions 2 in lattices having no thermosiphon heat exchange units 1 embedded currently can be removed to embed new thermosiphon heat exchange units 1, so that heat dissipation performance of the heat dissipation apparatus can be improved. In Embodiment 3 of this invention, only 2 thermosiphon heat exchange units 1 are provided as an example.

Furthermore, the number of fan units 4 also can be determined according to required heat dissipation performance. When it is required to improve heat dissipation performance, newly added fan units 4 can be embedded in half lattices constructed by the frame 3 and first partitions 2. Also, according to the strength of air flow in the internal circulation air passage and the external circulation air passage, the same number or different numbers of fan units 4 can be disposed in the internal circulation air passage and the external circulation air passage. When adding new fan units 4, it is possible to add new fan units 4 in merely one of the internal circulation air passage and the external circulation air passage if necessary. In Embodiment 3, only one fan unit 4 is disposed in each of the internal circulation air passage and the external circulation air passage as anexemple.

In Embodiment 3 of this invention, preferably, the lattice, the thermosiphon heat exchange unit 1 and the fan unit 4 are all rectangular. Particularly, the lattice and the thermosiphon heat exchange unit may have the same shape. The width of the fan unit 4 is equal to the width of the lattice and the thermosiphon heat exchange unit 1, the height of the fan unit 4 is half of the height of the lattice and the thermosiphon heat exchange unit 1. In other embodiments, the lattice, the thermosiphon heat exchange unit 1, and the fan unit 4 may have other shapes.

The heat dissipation apparatus of any one of Embodiment 1 to Embodiment 3 of this invention can be applied to an outdoor communication device. Particularly, the outdoor communication device comprises the heat dissipation apparatus and one or more service boards, the heat dissipation apparatus being one mentioned in any one of Embodiment 1 to Embodiment 3 of this invention. The number of the thermosiphon heat exchange units in the heat dissipation apparatus can be determined according to the number of the service boards. When the outdoor communication device is updated, the number of the service boards may increase, and additional heat dissipation apparatus may be added in the heat dissipation apparatus correspondingly. Further, the number of the fan units in the heat dissipation apparatus also can be determined based on the number of the service boards. When the outdoor communication device is updated, the number of the service boards may increase, fan units may be added in the heat dissipation apparatus correspondingly.

In Embodiment 1 to Embodiment 3 of this invention, a modular design is adopted, the frame of the heat dissipation apparatus has a plurality of lattices in which a plurality of thermosiphon heat exchange units can be embedded, the number of the embedded thermosiphon heat exchange units can be increased or decreased at any time depending on heat dissipation performance that is required currently, the synchronized update of the heat dissipation apparatus with the device where the heat dissipation apparatus is disposed can be implemented, a waste in cost caused when the heat dissipation apparatus is designed according to its maximum required heat dissipation performance can be avoided, and manufacturing cost can be saved. In addition, the heat dissipation apparatus is plug-and-play, which may facilitate mount and maintenance, and the update requirement of devices can be met.

Note that every method embodiment described above is described with a combination of a series of actions, however, it will be appreciated by those skilled in the art that this invention do not limit to the action sequence described herein, as according to this invention some steps can be carried out in other orders or simultaneously. Secondly, those skilled in the art should understand that the embodiments described in this specification are all preferable embodiments, and actions or modules involved in these embodiments are not necessarily needed by this invention.

In the above embodiments, each of them is emphasized differently, so parts that are not detailed in one embodiment can be found in the relative description of other embodiments.

Those ordinary skilled in the art may understand that all or part steps of the above method embodiments can be implemented by program instructions relevant hardware, the program described above can be stored in a computer readable storage medium, which when executed may perform steps contained in the above method embodiments. The storage medium described above may comprise: ROM, RAM, magnetic disks, optical disks and various mediums capable of storing program codes.

At last, it should be noted that the above embodiments are merely given to illustrate the technical solution of this invention, and are not limitation of this invention. Although this invention has been described in detail according to the above embodiments, those skilled in the art may appreciate that modifications to the technical solution described in various embodiment or alternations of its some parts can be made; those modifications and alternations may not cause subject matters of corresponding technical solutions to depart from the scopes of the technical solutions of various embodiments of this invention.

## Claims

1. A heat dissipation apparatus, comprising:
one or more thermosiphon heat exchange units (1);
one or more first partitions (2); and
a frame (3) having at least two lattices;
**characterized in that**
wherein each of the one or more thermosiphon heat exchange units (1) is embedded in one lattice of the at least two lattices, and wherein each lattice of the at least two lattices having no thermosiphon heat exchange unit (1) embedded therein is disposed with one of the one or more first partitions (2) to partition the lattice into an upper portion and a lower portion, wherein the first partition (2) is detachable,
the thermosiphon heat exchange unit (1) comprises:
a condensation end collection pipe (11) in the upper portion of the thermosiphon heat exchange unit (1);
a vapor end collection pipe (12) in the lower portion of the thermosiphon heat exchange unit (1);
at least two cooling tubules (13) which are connected to the vapor end collection pipe (12) and the condensation end collection pipe (11);
cooling fins (14) evenly distributed between every two cooling tubules (13); and
a second partition (15) that partitions the thermosiphon heat exchange unit (1) into an upper portion and a lower portion;
wherein refrigerant is accommodated in the vapor end collection pipe (12), the condensation end collection pipe (11), and the cooling tubules (13),
the upper portion of the lattice is a first half lattice, and the lower portion is a second half lattice; and wherein the heat dissipation apparatus further comprises:
one or more fan units (4);
wherein,
each fan unit (4) of the one or more fan units (4) is embedded in the first half lattice or the second half lattice,
the lower portion of all of the lattices is arranged in an internal circulation air passage to contact with heat air produced by a device where the heat dissipation apparatus is located, and the upper portion of all of the lattices is arranged in an external circulation air passage to contact cool air outside the heat dissipation apparatus, wherein the internal circulation air passage is isolated from the external circulation air passage by a plurality of first and second partitions; and
a number of the thermosiphon heat exchange units (1) is determined according to a number of the one or more service boards to be cooled.

2. The heat dissipation apparatus according to claim 1, **characterized in that** the refrigerant comprises at least one of: ammonia, acetone, and R134A type refrigerant.

3. The heat dissipation apparatus according to any one of claims 1 to 2, **characterized in that** the lattices and the thermosiphon heat exchange units (1) have a same shape.

4. The heat dissipation apparatus according to any one of claims 1 to 2, **characterized in that**:
the lattices, the thermosiphon heat exchange units (1), and the fan units (4) are all rectangular in shape,
a width of the fan units is equal to a width of the lattices and the thermosiphon heat exchange units (1),
a height of the fan units (4) is half of a height of the lattices and the thermosiphon heat exchange units (1).

5. An outdoor communication device comprising one or more service boards, and the heat dissipation apparatus (1) of any one of claims 1 to 4.

## Patentansprüche

1. Wärmeableitungsvorrichtung, die Folgendes umfasst:
eine oder mehrere Thermosiphon-Wärmetauscheinheiten (1);
eine oder mehrere erste Trennwände (2); und
einen Rahmen (3), der wenigstens zwei Gitter aufweist;
**dadurch gekennzeichnet, dass**
wobei jede aus der einen oder den mehreren Thermosiphon-Wärmetauscheinheiten (1) in ein Gitter aus den wenigstens zwei Gittern eingebettet ist und wobei jedes Gitter aus den wenigstens zwei Gittern, das keine darin eingebettete Thermosiphon-Wärmetauscheinheit (1) aufweist, mit einer aus der einen oder den mehreren ersten Trennwänden (2) angeordnet ist, um das Gitter in einen oberen Abschnitt und einen unteren Abschnitt zu unterteilen, wobei die erste Trennwand (2) abnehmbar ist,
wobei die Thermosiphon-Wärmetauscheinheit (1) Folgendes umfasst:
ein Kondensationsendsammelrohr (11) in dem oberen Abschnitt der Thermosiphon-Wärmetauscheinheit (1);
ein Dampfendsammelrohr (12) in dem unteren Abschnitt der Thermosiphon-Wärmetauscheinheit (1);
wenigstens zwei Kühlröhrchen (13), die mit dem Dampfendsammelrohr (12) und dem Kondensationsendsammelrohr (11) verbunden sind;
Kühlrippen (14), die gleichmäßig zwischen jeweils zwei Kühlröhrchen (13) verteilt sind; und
eine zweite Trennwand (15), die die Thermosiphon-Wärmetauscheinheit (1) in einen oberen Abschnitt und einen unteren Abschnitt unterteilt;
wobei ein Kältemittel in dem Dampfendsammelrohr (12), dem Kondensationsendsammelrohr (11) und den Kühlröhrchen (13) aufgenommen ist,
der obere Abschnitt des Gitters ein erstes Halbgitter ist und der untere Abschnitt ein zweites Halbgitter ist; und wobei die Wärmeableitungsvorrichtung ferner Folgendes umfasst:
eine oder mehrere Lüftereinheiten (4);
wobei
jede Lüftereinheit (4) aus der einen oder den mehreren Lüftereinheiten (4) in dem ersten Halbgitter oder dem zweiten Halbgitter eingebettet ist,
der untere Abschnitt aller Gitter in einem inneren Zirkulationsluftkanal angeordnet ist, um in Kontakt mit warmer Luft zu sein, die durch ein Gerät produziert wird, wo sich die Wärmeableitungsvorrichtung befindet, und der obere Abschnitt aller Gitter in einem äußeren Zirkulationsluftkanal angeordnet ist, um in Kontakt mit kühler Luft außerhalb der Wärmeableitungsvorrichtung zu sein, wobei der innere Zirkulationsluftkanal von dem äußeren Zirkulationsluftkanal durch mehrere erste und zweite Trennwände isoliert ist; und
eine Anzahl der Thermosiphon-Wärmetauscheinheiten (1) gemäß einer Anzahl der einen oder mehreren Dienstplatinen, die gekühlt werden sollen, bestimmt wird.

2. Wärmeableitungsvorrichtung nach Anspruch 1, **dadurch gekennzeichnet, dass** das Kältemittel wenigstens eines der Folgenden umfasst: Ammoniak, Aceton und ein Kältemittel vom R134A-Typ.

3. Wärmeableitungsvorrichtung nach einem der Ansprüche 1 bis 2, **dadurch gekennzeichnet, dass** die Gitter und die Thermosiphon-Wärmetauscheinheiten (1) die gleiche Form aufweisen.

4. Wärmeableitungsvorrichtung nach einem der Ansprüche 1 bis 2, **dadurch gekennzeichnet, dass**:
die Gitter, die Thermosiphon-Wärmetauscheinheiten (1) und die Lüftereinheiten (4) alle von rechteckiger Form sind,
eine Breite der Lüftereinheiten gleich einer Breite der Gitter und der Thermosiphon-Wärmetauscheinheiten (1) ist,
eine Höhe der Lüftereinheiten (4) die Hälfte einer Höhe der Gitter und der Thermosiphon-Wärmetauscheinheiten (1) ist.

5. Kommunikationsvorrichtung für den Außenbereich, die eine oder mehrere Dienstplatinen und die Wärmeableitungsvorrichtung (1) nach einem der Ansprüche 1 bis 4 umfasst.

## Revendications

1. Appareil de dissipation de chaleur, comprenant:
une ou plusieurs unité(s) d'échange de chaleur à thermosiphon (1);
une ou plusieurs première(s) cloison(s) (2); et
un cadre (3), comportant au moins deux grilles,
**caractérisé en ce que**:
dans lequel chacune des une ou plusieurs unité(s) d'échange de chaleur à thermosiphon (1) est encastrée dans une grille des au moins deux grilles, et dans lequel chaque grille des au moins deux grilles qui ne présente aucune unité d'échange de chaleur à thermosiphon (1) encastrée dans celle-ci est disposée avec une des une ou plusieurs première(s) cloison(s) (2) pour scinder la grille en une partie supérieure et une partie inférieure, dans lequel la première cloison (2) est détachable,
l'unité d'échange de chaleur à thermosiphon (1) comprend:
un tuyau de collecte d'extrémité de condensation (11) dans la partie supérieure de l'unité d'échange de chaleur à thermosiphon (1);
un tuyau de collecte d'extrémité de vapeur (12) dans la partie inférieure de l'unité d'échange de chaleur à thermosiphon (1):
au moins deux tubules de refroidissement (13) qui sont connectées au tuyau de collecte d'extrémité de vapeur (12) et au tuyau de collecte d'extrémité de condensation (11);
des ailettes de refroidissement (14) qui sont distribuées de façon uniforme toutes les deux tubules de refroidissement (13); et
une seconde cloison (15) qui scinde l'unité d'échange de chaleur à thermosiphon (1) en une partie supérieure et une partie inférieure,
dans lequel un réfrigérant est reçu dans le tuyau de collecte d'extrémité de vapeur (12), le tuyau de collecte d'extrémité de condensation (11) et les tubules de refroidissement (13),
la partie supérieure de la grille est une première demi-grille, et la partie inférieure est une seconde demi-grille,
et dans lequel l'appareil de dissipation de chaleur comprend en outre:
une ou plusieurs unité(s) de ventilateur (4);
dans lequel
chaque unité de ventilateur (4) des une ou plusieurs unité(s) de ventilateur (4) est encastrée dans la première demi-grille ou dans la seconde demi-grille,
la partie inférieure de toutes les grilles est agencée dans un passage de circulation d'air interne afin d'entrer en contact avec de l'air de chauffage produit par un dispositif où l'appareil de dissipation de chaleur est situé, et
la partie supérieure de toutes les grilles est agencée dans un passage de circulation d'air externe afin d'entrer en contact avec de l'air de refroidissement à l'extérieur de l'appareil de dissipation de chaleur,
dans lequel le passage de circulation d'air interne est isolé du passage de circulation d'air externe par une pluralité de premières et secondes cloisons, et
un nombre des unités d'échange de chaleur à thermosiphon (1) est déterminé en fonction d'un nombre des un ou plusieurs panneau(x) de service à refroidir.

2. Appareil de dissipation de chaleur selon la revendication 1, **caractérisé en ce que** le réfrigérant comprend au moins un composant parmi l'ammoniac, l'acétone et un réfrigérant de type R134A.

3. Appareil de dissipation de chaleur selon l'une quelconque des revendications 1 et 2, **caractérisé en ce que** les grilles et les unités d'échange de chaleur à thermosiphon (1) ont une même forme.

4. Appareil de dissipation de chaleur selon l'une quelconque des revendications 1 et 2, **caractérisé en ce que**:
les grilles, les unités d'échange de chaleur à thermosiphon (1) et les unités de ventilateur (4) sont toutes de forme rectangulaire,
une largeur des unités de ventilateur est égale à une largeur des grilles et des unités d'échange de chaleur à thermosiphon (1),
une hauteur des unités de ventilateur (4) est égale à la moitié d'une hauteur des grilles et des unités d'échange de chaleur à thermosiphon (1).

5. Dispositif de communication extérieur comprenant un ou plusieurs panneau(x) de service, et l'appareil de dissipation de chaleur (1) selon l'une quelconque des revendications 1 à 4.
